# EUROPEAN PATENT APPLICATION

(11) **EP 4 626 157 A1**
(43) Date of publication of application: **01.10.2025**
(21) Application number: 25165921.5
(22) Date of filing: 25.03.2025
(51) Int. Cl.: H05K 7/14, H05K 7/20, F04D 13/06

(54) **REDUCED CONDENSATION ELECTRONIC INPUT/OUTPUT APPARATUS**

(30) Priority: 28.03.2024 IT 202400007006
(71) Applicant: Dab Pumps S.p.A., 35035 Mestrino (Padova) (IT)
(72) Inventor: AGNOLUCCI, Barbara, 35035 Mestrino (PD) (IT); CAPPOCCHIN, Michele, 35035 Mestrino (PD) (IT)
(74) Representative: De Filippis, Sara

(57) **Abstract**

The invention concerns an input/output electronic apparatus (10) for pumping systems comprising an enclosure (1) for housing and protecting the internal components of the input/output electronic apparatus (10), an electronic control board (2) housed in said enclosure (1) and provided with one or more through holes (26), a dissipator (3) housed in said enclosure (1) configured to dissipate heat produced by the input/output electronic apparatus (10). The enclosure (1) has one or more projecting elements (16) suitable for inserting into said holes (26) of said electronic control board (2) so that the closing of said enclosure (1) causes the locking of said electronic control board (2) within said enclosure (1).

## Description

The present invention concerns an electronic input/output apparatus, in particular of a current, with reduced condensation.

### Field of invention

The invention fits into the technical field of electronic apparatuses for pumps and pumping systems, in particular in the technical field of electronic apparatuses for controlling the input and output of a current, such as inverters or the like.

### Prior art

It is known in the field that pumping systems and in particular pumps require electronic input/output apparatuses such as current inverters or inverters for their correct operation.

These devices, despite being generally known in any field and sector of electronics, still have some limitations when applied to pumps or pumping systems.

These limitations lead to reductions in the efficiency, performance and potential use of the pumps themselves, also increasing some risks such as the production of condensation inside the electronic components.

Further limitations are also due to the need to create such electronic input/output apparatuses according to certain size or positioning constraints of the components.

Electronic input/output apparatuses also have limitations and problems related to the presence of condensation. These problems are often emphasized by metal parts, which lead to the creation of thermal bridges.

A clear example of such metal parts is given by the fastening elements, such as screws or bolts, which keep the components of the electronic input/output apparatuses connected.

A further limitation is given by the lack of simplicity of the assembly and disassembly given by the electronic input/output apparatuses, which often require complex and long manual operations, for example for the replacement and maintenance of the electronic components.

There is therefore a need to create electronic input/output apparatuses such as current inverters or inverters with improved characteristics and performance.

### Purpose of the invention

The purpose of the present invention is, therefore, to provide an electronic input/output apparatus with reduced condensation capable of solving the drawbacks and critical issues mentioned above.

Another purpose of the present invention is to create an electronic input/output apparatus, in which condensation does not occur.

A further object of the present invention is to provide an electronic input/output apparatus with reduced condensation having housing chambers that isolate the fastening elements.

Another purpose of the present invention is to create an electronic input/output apparatus that reduces thermal bridges and reduces the volumes.

A further purpose of the present invention is to provide an electronic input/output apparatus, which simplifies the assembly and the disassembly operations.

Another purpose of the present invention is to create an electronic input/output apparatus that facilitates maintenance and replacement of electronic components.

Another purpose of the present invention is to create a reduced condensation electronic input/output apparatus, which simplifies and optimizes the assembly of the components.

A further purpose of the present invention is to provide a reduced condensation electronic input/output apparatus, which makes the production and the assembly process simpler, quicker, cheaper, and more repeatable even automatically.

A further aim of the present invention is to provide a reduced condensation electronic input/output apparatus, which is easy and economical to manufacture by virtue of the advantages achieved.

These and other purposes are achieved by an electronic input/output apparatus according to the attached independent claim.

Further detailed technical features are reported in the attached dependent claims.

It is, therefore, object of the present invention an input/output electronic apparatus for pumping systems comprising an enclosure for housing and protecting the internal components of the input/output electronic apparatus, an electronic control board housed in said enclosure and provided with one or more through holes, a dissipator housed in said enclosure configured to dissipate heat produced by the input/output electronic apparatus.

Preferably, the enclosure has one or more projecting elements suitable for inserting into said holes of said electronic control board so that the closing of said enclosure causes the locking of said electronic control board within the enclosure.

In a preferred embodiment, the projecting elements have cavities covered by covering elements.

Even more preferably, the cavities of the projecting elements are through holes.

Further, the fastening means for fastening the electronic input/output apparatus to the pumping system pass through the through holes of the projecting elements via through holes present on the dissipator and are housed in the bottom of the cavities of the projecting elements.

In a further embodiment, one or more grounding lugs connect the electronic control board with the fastening means so as to enable the grounding of the electronic control board.

Preferably, the grounding lugs are made by co-molding with the enclosure.

Furthermore, the grounding lugs have a substantially "L" shape. in which a first end is suitable for coming into contact with the electronic control board, and a second end is suitable for coming into contact with the fastening means.

In a further embodiment, the second end of the grounding lugs is made with a circular shape, in which a through hole is made for the insertion of the fastening means.

Preferably, the second end of the grounding lugs is in contact with a grounding element fixed to one of said fastening means.

Even more preferably, the grounding element fixed to one of the fastening means is made of brass.

### Brief description of the figures

The present invention will now be described, by way of example, but not by way of limitation, according to some of its preferred embodiments, and with the help of the attached figures, wherein:

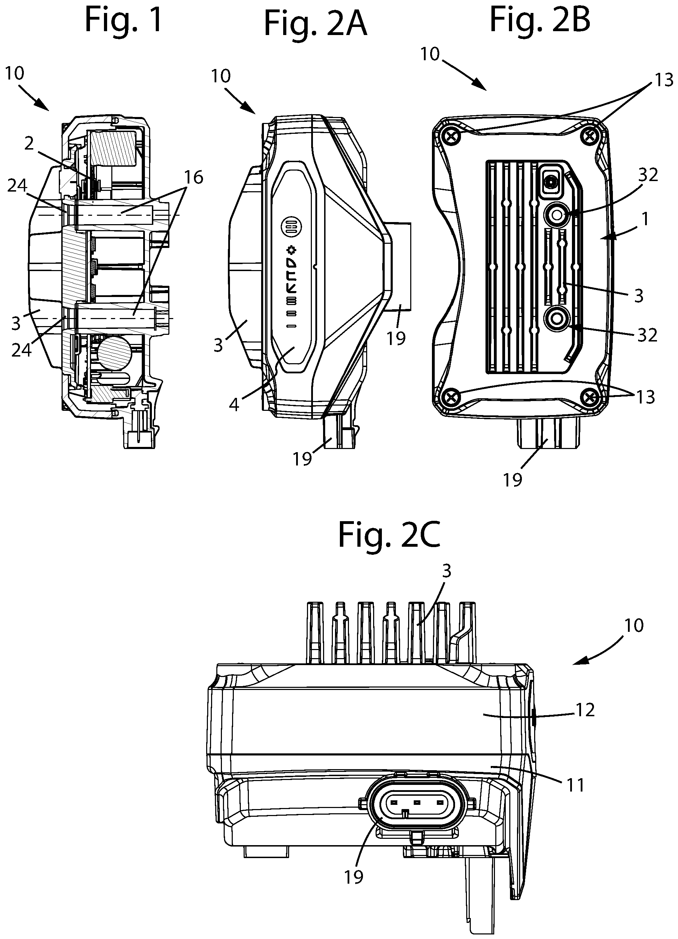

- figure 1 is a sectional view of the electronic input/output apparatus according to the invention;
- figures 2A-2C are side views of the electronic input/output apparatus according to the invention;
- figure 3 is an exploded view of the electronic input/output apparatus according to the invention;
- figures 4A and 4B are two perspective views of two different embodiments of the electronic input/output apparatus, according to the invention, connected to a pump, with fixing means removed;

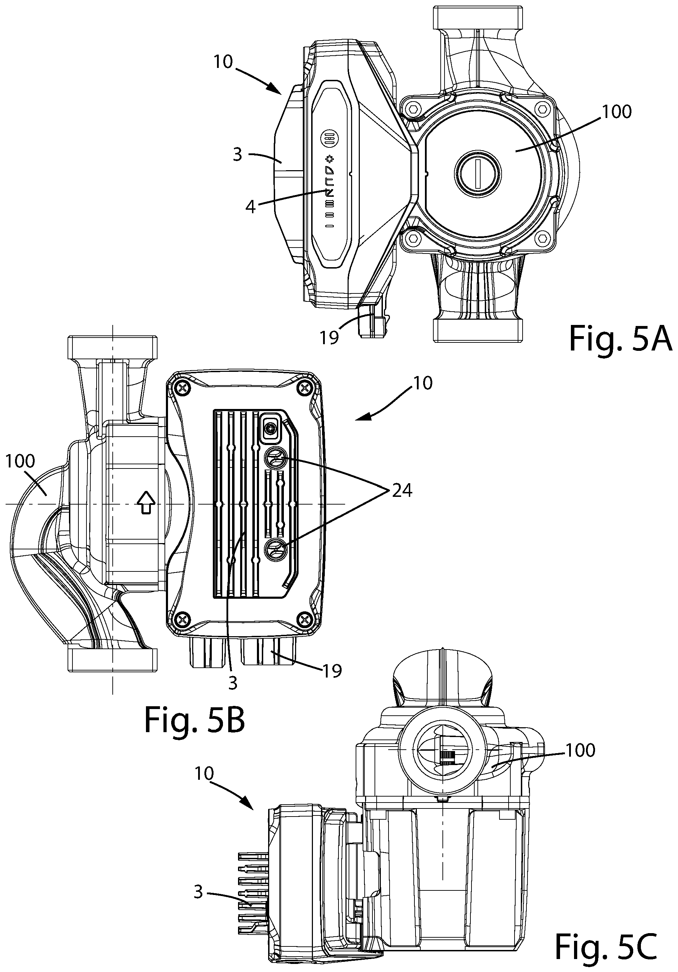

- figure 5A is a front view of the electronic input/output apparatus of figure 4A;
- figures 5B and 5C are two side views of the electronic input/output apparatus of figure 4A;
- figure 6 is a perspective view of a portion of the electronic input/output apparatus according to the invention with evidence of the grounding elements;
- figure 7 is a sectional view of a portion of the electronic input/output apparatus, in which the fixing means and the grounding blade according to the invention are present.

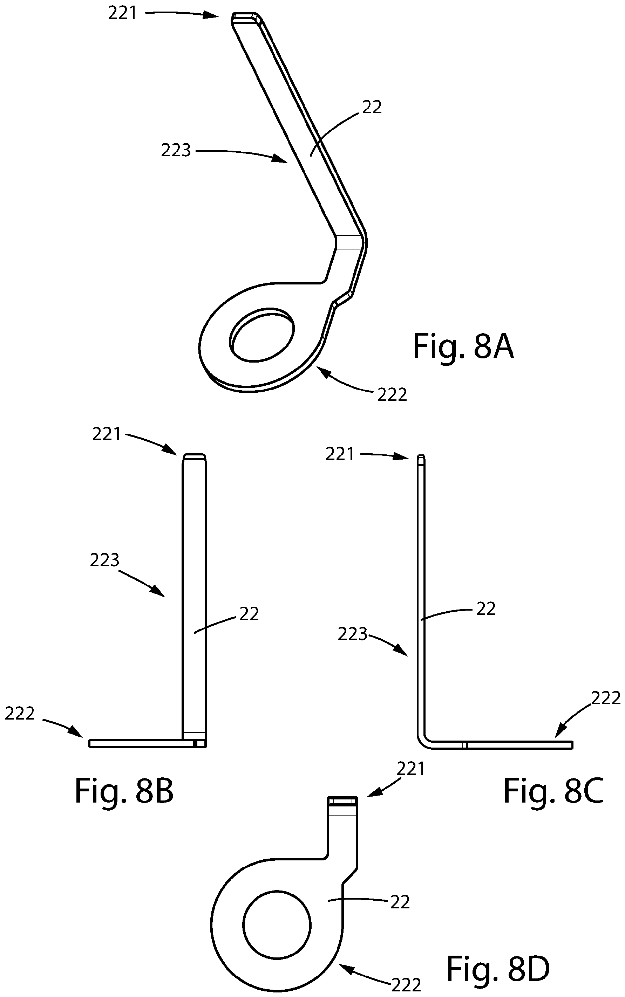

- figure 8A is a perspective view of the grounding blade comprised in the electronic input/output apparatus according to the invention;
- figures 8B and 8C are two side views of the grounding blade of figure 8A;
- figure 8D is a top view of the grounding plate in figure 8A.

### Detailed description

With reference to the mentioned figures, a preferred embodiment of an electronic input/output apparatus according to the invention is shown.

Referring to the figures above, the reduced condensation electronic input/output apparatus object of the invention is indicated with the numerical reference 10 and, in its first embodiment, according to the present invention, comprises an enclosure 1 for housing the various components present inside it, an electronic control board 2 and a dissipator 3.

The enclosure 1 is generally made in two parts, in order to facilitate the insertion of the components inside and the disassembly of the apparatus 10 itself in case of failures or maintenance.

In preferred embodiments, as visible in the figures, the enclosure 1 comprises a board holder 11 and a cover 12.

Advantageously, the board holder 11 and the cover 12 are fixed to each other by means of suitable fastening elements 13.

More in detail, the fastening elements 13 are inserted into the through holes present in the cover 12 and fixed in the respective shaped seats 17 present in the board holder 11 and projecting with respect to the seat of the board 111.

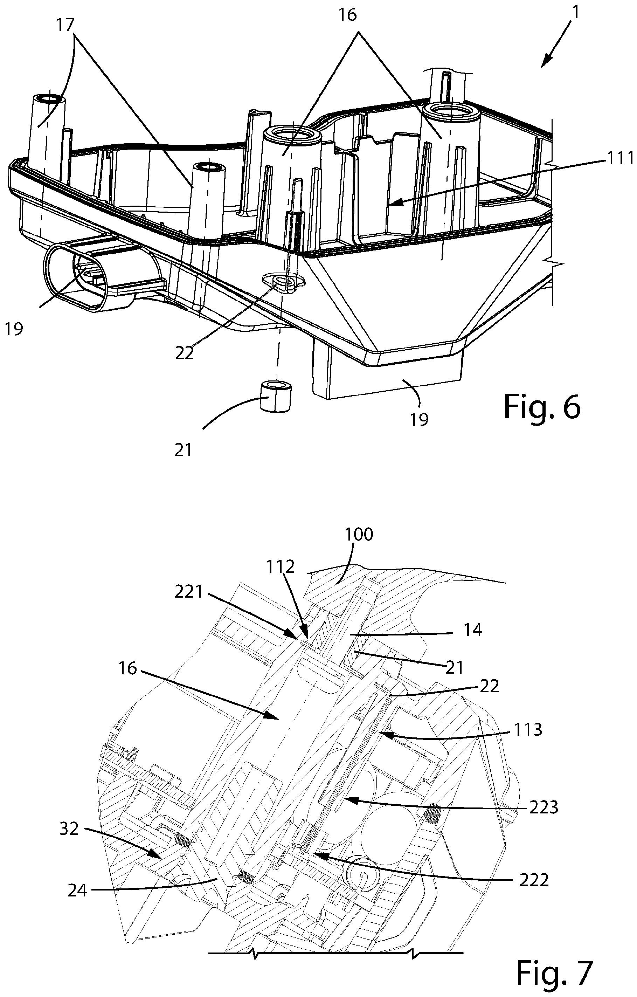

Even more advantageously, as visible in figure 7, to fix the enclosure 1 to a pump 100, for example in its motor enclosure, further fastening means 14 are used.

The fastening means 14 also allow the electronic board 2 and the dissipator 3 to be kept in position and provide greater stability to the entire electronic input/output apparatus 10.

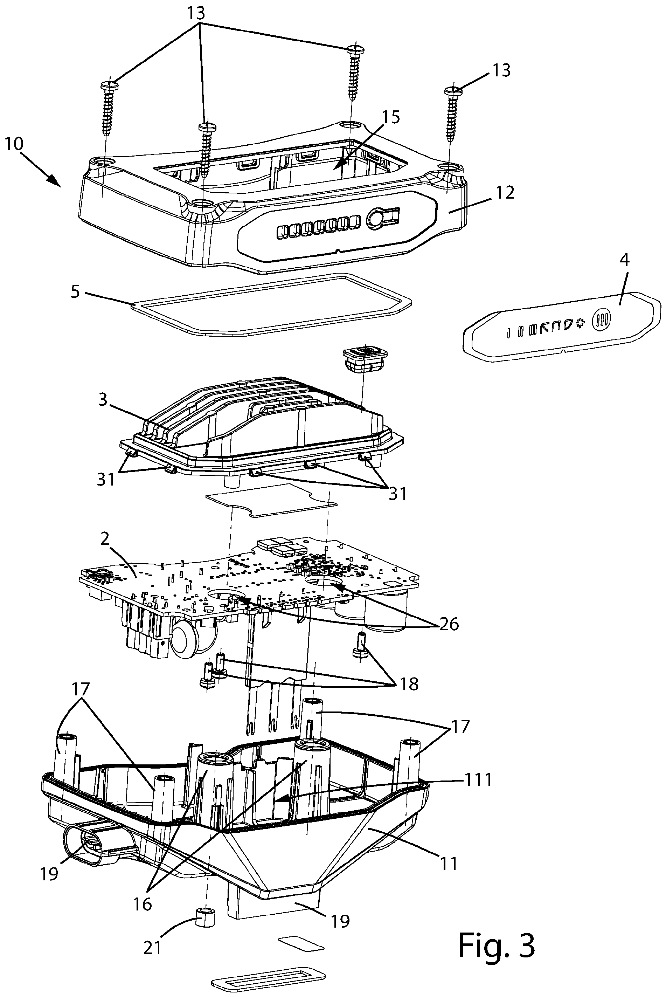

As it can be seen for example in figure 3, the enclosure 1 and, in particular, the board holder 11 has elements 16 projecting with respect to the seat of the board 111, which pass through the through holes 26 present in the electronic board 2, so as to come into contact with the seat of the board 111.

Advantageously, the projecting elements 16 have a diameter or in any case a dimension compatible with that of the holes 26, so that they can fit inside them or in any case prevent the movements of the electronic control board 2 inside the enclosure 1.

In detail, the seat of the board 111 is shaped so as to be able to accommodate the components present on the board 2 and support bord 2 itself, so that it is as close as possible to the dissipator.

The fastening means 14 are inserted through the through holes 32 present on the dissipator 3 inside cavities present in the respective projecting elements 16, allowing fixing to the pumping system or to the pump 100.

In this way, advantageously, the fastening means 14 are not on the same plane as the board 2, but further inside the projecting elements 16, in correspondence with the junction of the electronic input/output apparatus 10 with the pump.

More in detail, the fastening means 14 are positioned on the bottom of the cavities of the respective projecting elements 16.

Preferably, the cavities of said one or more projecting elements 16 are through holes.

Advantageously, the covering elements 24 are used to plug the cavities of the projecting elements 16 once the fastening means 14 have been inserted.

These covering elements 24, which perform the function of plugs for the cavities of the projecting elements 16, also prevent dirt, dust or liquids from being positioned inside the projecting elements 16 themselves.

In preferred embodiments of the present invention, a grounding element 21, for example made of brass, is interposed between the fastening means 14 and the pump motor enclosure 100.

Advantageously, the grounding element 21 is fixed to one of the fastening means and contributes to the grounding of the electronic board 2 of the electronic input/output apparatus 10 as will also be described below.

Preferably, the grounding element 21 has a cylindrical in shape.

Again advantageously, the aforementioned structure allows the size and ease of assembly and disassembly of the input/output apparatus 10 to be reduced.

Even more advantageously, the projecting elements 16 allow the fastening elements 14 to be isolated from the inside of the electronic input/output apparatus 10, so that the fastening means 14, if made of metal, do not create thermal bridges which can cause the production of condensation inside the electronic input/output apparatus.

In this way, it is also possible to isolate the cold parts from the inside of the electronic input/output apparatus 10.

Advantageously, the electronic input/output apparatus 10 provides a grounding lug 22.

More specifically, the grounding lug 22 and the grounding element 21 are in contact with each other and electrically connect the electronic control board 2 with the pump 100, to ground the same electronic board 2.

In a preferred embodiment of the present invention, the grounding lug 22 is made of brass.

Advantageously, the grounding lug 22 is co-molded into the enclosure 1 and more particularly into the board holder 11.

Preferably, the grounding lug 22 has a substantially "L" shape having a first end 221, suitable for contacting the electronic control board 2, and a second end 222 suitable for contacting one of the fastening means 14, and perpendicular to the main body 223.

Advantageously, the second end 222 of the grounding lug 22 is made with a circular shape, in which a through hole is made for the insertion of one of the fastening means 14, and is inserted into the bottom of the cavity of the respective projecting element 16 via a slot 112.

The main body 223 is inserted into a suitable seat 113 of the enclosure 1, suitable for thermally isolating the lug 22 from the components of the board 2.

The first end 221 is the only portion of the lug 22 itself that comes into contact with the board 2, so as to carry out the grounding, avoiding thermal bridges as much as possible inside the electronic input/output apparatus 10.

With reference to figure 3, the dissipator 3 can have protruding elements 31 capable of snapping into the respective seats present in the enclosure 1 to improve the fastening between the dissipator 3 and the enclosure 1.

In the embodiments visible in the figures, the dissipator 3 snaps onto the cover 12.

Again, with reference to figure 3, the electronic control board 2 and the dissipator 3 are also fastened to each other by means of further fastening means 18.

In a preferred embodiment, the cover 12 can have an opening 15, to allow the escape of at least a portion of the dissipator 3.

The enclosure 1 can also have a display 4 for viewing parameters, signals, and information and for the control and management of the electronic input/output apparatus by a user.

In the embodiments visible in the figures, the display 4 is present on the cover 12 of the enclosure 1.

Advantageously, the display 4 can be positioned in a position of the enclosure 1 that is easily reachable by a user.

Even more advantageously, the display 4 is of the touch-screen type, and has a layout and interface that is highly comprehensible and intuitive to the user.

Preferably, a gasket 5 is placed between the enclosure 1 and the dissipator 3.

Other gaskets may be present in other positions depending on needs and requirements.

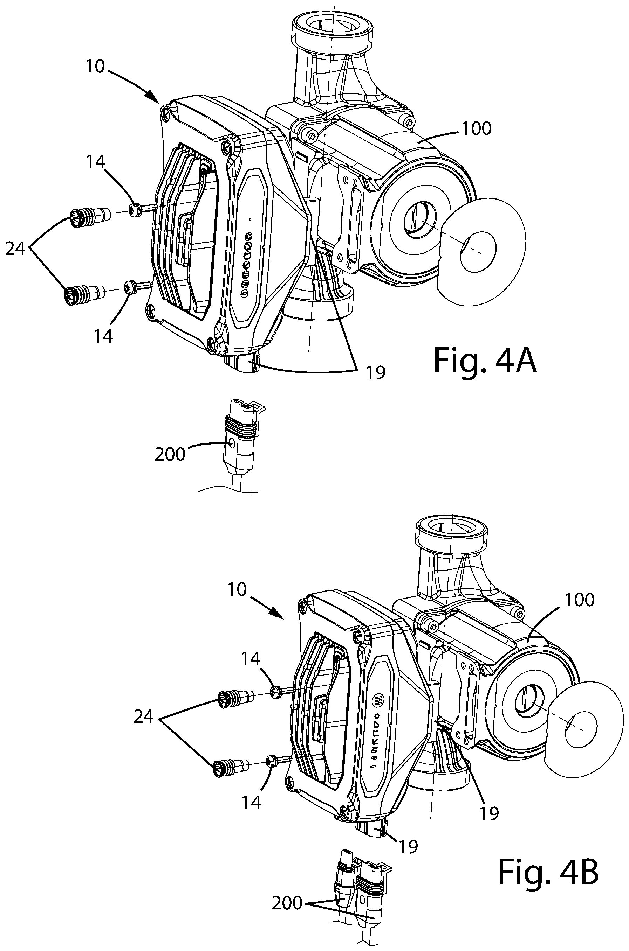

As visible for example in figures 4A and 4B, the enclosure 1 can also have connection portions 19 for the connection with a pump 100 or a pumping system, in particular with the motor enclosure of a pump 100, and with one or more cables 200.

Advantageously, the connection portions 19 allow the connection of the pump 100 and the cables 200 directly with the electronic control board 2.

This connection occurs for example by means of appropriate connectors soldered onto the control board 2 and housed in the connection portions 19.

Advantageously, the connection portions 19 are shaped to follow the shape and adherently cover the connectors soldered onto the electronic board 2, which can be standard or specially made depending on needs and requirements.

In other words, the connectors soldered onto the electronic board 11 pass through the connection portions 19 present on the enclosure 1, and more particularly on the board holder 11.

More in detail, in the connection portion 19 configured to connect to the pump 100 there are power supply/signal blades suitable for electrically connecting the electronic input/output apparatus 10 and the pump 100.

These power/signal blades are co-molded into the enclosure 1, and, in particular, into the board holder 11, in correspondence with the respective connection portion 19.

Advantageously, the electronic input/output apparatus 10 allows for a lightening and reduction of volumes and simplifies the assembly of the components present inside it.

From the description provided, the features of the electronic input/output apparatus, object of the invention, just as the advantages are clear too.

It is clear, finally, that numerous other variations can be made to the apparatus at issue, without departing from the principles of novelty inherent in the inventive idea, just as it is clear that, in the practical implementation of the invention, the materials, the shapes and the dimensions of the illustrated details may be any according to needs and they may be replaced with other equivalent ones.

Where the features and techniques mentioned in any claims are followed by reference marks, such reference marks have been included for the sole purpose of increasing the intelligibility of the claims and, accordingly, such reference marks have no limiting effect on the interpretation of each element identified by way of example by these reference signs.

## Claims

1. An input/output electronic apparatus (10) for pumping systems comprising:
- an enclosure (1) for housing and protecting the internal components of the input/output electronic apparatus (10),
- an electronic control board (2) housed in said enclosure (1) and provided with one or more through holes (26),
- a dissipator (3) housed in said enclosure (1) configured to dissipate heat produced by the input/output electronic apparatus (10),
**characterized in that**
said enclosure (1) has one or more projecting elements (16) suitable for inserting into said holes (26) of said electronic control board (2)
so that the closing of said enclosure (1) causes the locking of said electronic control board (2) within said enclosure (1).

2. Input/output electronic apparatus (10) according to claim 1 **characterised by** the fact that
the projecting elements (16) have cavities
and by the fact of comprising covering elements (24) suitable for plugging the cavities of said one or more projecting elements (16).

3. Input/output electronic apparatus (10) according to claim 2, **characterised in that**
the cavities of said one or more projecting elements (16) are through holes.
and by the fact of providing one or more fastening means (14) for fixing to said pumping system (100), which pass through said through holes of said one or more projecting elements (16) by means of through holes on the dissipator (3) and are housed at the bottom of the respective cavities.

4. Input/output electronic apparatus (10) according to any one or more of the preceding claims **characterised by** comprising one or more grounding lugs (22) for connecting said electronic control board (2) with one or more of said fastening means (14), so as to enable the grounding of said electronic control board (2).

5. Input/output electronic apparatus (10) according to claim 4 **characterised by** the fact that said one or more grounding lugs (22) are made by co-moulding with the enclosure (1).

6. Input/output electronic apparatus (10) according to one or more of claims 4-5 **characterised by** the fact that said one or more grounding lugs (22) have a substantially "L" shape in which a first end (221) is suitable for contacting said electronic control board (2) and a second end (222) is suitable for contacting one of said fastening means (14).

7. Input/output electronic apparatus (10) according to claim 6 **characterised by** the fact that the second end (222) of said one or more grounding lugs (22) is made in a circular shape in which a through-hole for insertion of one of said fastening means (14) is provided.

8. Input/output electronic apparatus (10) according to claim 6 or 7, **characterised in that** the second end (222) of said one or more grounding lugs (22) is in contact with a grounding element (21) fixed to one of said fastening means (14).

9. Input/output electronic apparatus (10) according to claim 8, **characterised in that** the grounding element (21) fixed to one of said fastening means (14) is made of brass.
